# EUROPEAN PATENT APPLICATION

(11) **EP 4 750 233 A1**
(43) Date of publication of application: **27.05.2026**
(21) Application number: 24923375.0
(22) Date of filing: 12.10.2024
(51) Int. Cl.: H05K 5/02, B21D 35/00, G06F 1/16

(54) **PLATE STRUCTURE AND MANUFACTURING METHOD THEREFOR, AND ELECTRONIC DEVICE**

(30) Priority: 06.02.2024 CN 202410174727
(71) Applicant: HUAWEI TECHNOLOGIES CO., LTD., Shenzhen 518129 (CN)
(72) Inventor: HUANG, Sixin, Shenzhen, Guangdong 518129 (CN); KING, Tehao, Shenzhen, Guangdong 518129 (CN); WU, Weijie, Shenzhen, Guangdong 518129 (CN); LI, Lei, Shenzhen, Guangdong 518129 (CN); WU, Baihua, Shenzhen, Guangdong 518129 (CN); LI, Gaochao, Shenzhen, Guangdong 518129 (CN)
(74) Representative: Grünecker Patent- und Rechtsanwälte PartG mbB
(86) International application number: PCT/CN2024/124527
(87) International publication number: WO 2025/167171

(57) **Abstract**

Embodiments of this application provide a plate structure and a method for manufacturing the same, and an electronic device, and relate to the field of electronic devices. The plate structure includes a plate body and a boss that are connected to form an integrally formed member, and the plate body has a counterbore. A second hole segment of the counterbore is at least partially formed in the boss and penetrates the boss. A circumferential surface of a first hole segment of the counterbore smoothly transitions to a first surface of the plate body via a fillet, and a radius of the fillet is less than or equal to 0.3 mm. A minimum distance between the circumferential surface of the first hole segment and a surface that is of the boss and that is away from the plate body is greater than or equal to 0.3 mm. The plate structure is formed by hot-stamping a plate substrate on a base, and the base has an abutting surface and a conical surface that face the plate substrate. A distance between a stamping part and the abutting surface is 0.6 to 0.8 times a thickness of the plate body. The plate structure takes into account advantages of aesthetics and good mechanical performance.

## Description

This application claims priority to Chinese Patent Application No. 202410174727.5, filed with the China National Intellectual Property Administration on February 6, 2024 and entitled "PLATE STRUCTURE AND METHOD FOR MANUFACTURING SAME, AND ELECTRONIC DEVICE", which is incorporated herein by reference in its entirety.

### TECHNICAL FIELD

Embodiments of this application relate to the field of electronic devices, and in particular, to a plate structure and a method for manufacturing the same, and an electronic device.

### BACKGROUND

With commercialization of electronic devices, market competition of the electronic devices is increasingly fierce. There are numerous factors affecting market competitiveness of the electronic device, such as functionality, portability, and aesthetics of the electronic device. Mechanical performance of a housing of the electronic device directly affects performance of the electronic device.

### SUMMARY

Embodiments of this application provide a plate structure and a method for manufacturing the same, and an electronic device, to improve mechanical performance of the plate structure.

To achieve the foregoing objective, the following technical solutions are used in this application.

According to a first aspect, an embodiment of this application provides a plate structure. The plate structure includes a plate body and a boss. The plate body has a counterbore, and a first surface and a second surface that are disposed opposite to each other in a thickness direction of the plate body. The boss is connected to the second surface and is connected to the plate body to form an integrally formed member. The counterbore includes a first hole segment and a second hole segment that communicate with each other, an opening of the first hole segment is located on the first surface, and the second hole segment is at least partially formed in the boss and penetrates the boss in the thickness direction of the plate body. An inner diameter of the first hole segment is greater than an inner diameter of the second hole segment. A circumferential surface of the first hole segment smoothly transitions to the first surface via a fillet, and a radius of the fillet is less than or equal to 0.3 mm. A minimum distance between the circumferential surface of the first hole segment and a surface that is of the boss and that is away from the plate body is greater than or equal to 0.3 mm. Therefore, when a user looks at the counterbore from the front, both the first surface and the fillet via which the circumferential surface of the first hole segment transitions to the first surface may be within a line-of-sight range of the user. Because the radius of the fillet is small and is less than or equal to 0.3 mm, an area of a circular arc surface via which the circumferential surface of the first hole segment transitions to the first surface is small, and the area of the circular arc surface observed by the user is small, making the counterbore more aesthetically pleasing. In addition, the minimum distance between the circumferential surface of the first hole segment and the surface that is of the boss and that is away from the plate body affects a bearing capacity of the boss. A larger distance indicates a greater bearing capacity of the boss and higher mechanical performance of the plate structure. In this embodiment of this application, the minimum distance of the plate structure is large and the radius of the fillet is small, and the plate structure takes into account advantages of aesthetics and good mechanical performance.

With reference to the first aspect, in some possible implementations, a surface that is of the boss and that is away from the first surface is a frustum surface, and the frustum surface is connected to the second surface. Structural strength of a joint between the boss with a third surface being the frustum surface and the plate body is high. This may improve the bearing capacity of the boss, and avoid tearing of the boss and the plate body due to a large interaction force between the boss and the plate body.

With reference to the first aspect, in some possible implementations, in the thickness direction of the plate body, a hole depth of the second hole segment is equal to a thickness of the plate body.

With reference to the first aspect, in some possible implementations, in the thickness direction of the plate body, a hole depth of the first hole segment ranges from 0.6 times to 0.8 times the thickness of the plate body. The hole depth of the first hole segment and the thickness of the plate body meet the foregoing relationship, and the minimum distance between the circumferential surface of the first hole segment and the surface that is of the boss and that is away from the plate body is greater than or equal to 0.3 mm. The foregoing minimum distance is greater than or equal to 0.3 mm, so that the bearing capacity of the boss is large, connection strength between the boss and the plate body is high, and the plate structure has excellent mechanical performance.

With reference to the first aspect, in some possible implementations, a hole depth of the first hole segment ranges from 0.38 mm to 0.48 mm. The hole depth of the first hole segment is within the foregoing range, and the minimum distance between the circumferential surface of the first hole segment and the surface that is of the boss and that is away from the plate body is greater than or equal to 0.3 mm. In this case, the structural strength between the boss and the plate body is high, and the mechanical performance of the plate structure is excellent.

With reference to the first aspect, in some possible implementations, the thickness of the plate body is less than or equal to 0.6 mm. Therefore, the thickness of the plate body is less than or equal to 0.6 mm, and the plate body has characteristics of small thickness and light weight.

With reference to the first aspect, in some possible implementations, a material of the plate structure includes a magnesium alloy. The magnesium alloy has advantages such as high strength, large elastic modulus, good heat dissipation, excellent shock absorption, and greater impact load bearing capability than an aluminum alloy.

With reference to the first aspect, in some possible implementations, the material of the plate structure is a plate material. The plate structure that is provided in this embodiment of this application and that is made of the plate material has advantages of high raw material utilization and low manufacturing costs.

With reference to the first aspect, in some possible implementations, a distance between an axis of the first hole segment and an axis of the second hole segment is less than or equal to 0.1 mm. Therefore, a smaller distance between the axis of the first hole segment and the axis of the second hole segment indicates a higher concentricity of the first hole segment and the second hole segment, and a more aesthetically pleasing appearance of the plate structure.

According to a second aspect, an embodiment of this application provides a method for manufacturing a plate structure. The method for manufacturing a plate structure includes: installing a plate substrate on a base, where the plate substrate has a first reference surface and a second reference surface that are disposed opposite to each other in a thickness direction of the plate substrate, the base has an abutting surface and a conical surface, both the abutting surface and the conical surface face the plate substrate, the abutting surface is in intimate contact with the first reference surface, and a gap exists between the conical surface and the first reference surface; and hot-stamping the plate substrate by using a stamping part to form a counterbore and a boss in the plate substrate, where a distance between the stamping part and the abutting surface is a in a direction perpendicular to the thickness direction of the plate substrate. The counterbore includes a first hole segment and a second hole segment that communicate with each other, an opening of the first hole segment is located on the first reference surface, and the second counterbore is at least partially formed in the boss and penetrates the boss in the thickness direction of the plate body. An inner diameter of the first hole segment is greater than an inner diameter of the second hole segment. A circumferential surface of the first hole segment smoothly transitions to the first reference surface via a fillet, and a radius of the fillet is less than or equal to 0.3 mm. A thickness of the plate body is T, and a is equal to (0.3 to 0.5)T.

Therefore, in a process in which the stamping part hot-stamps the plate substrate, the plate substrate moves close to the conical surface after deformation until the conical surface abuts against the plate substrate. In a process in which the stamping part continues to stamp the plate substrate, the conical surface and the stamping part press the plate substrate together until the counterbore and the boss are formed. Under an action of the conical surface and the stamping part, a portion of a material of the plate substrate accumulates between the boss and the plate body, so that a region between the boss and the plate body is thickened. In this way, even if a distance a between the stamping part and the abutting surface is small, the region between the boss and the plate body may still be thick, thereby ensuring excellent bearing strength and mechanical performance of the plate structure. In addition, the distance a between the stamping part and the abutting surface is smaller than the thickness T of the plate body, so that the radius of the fillet via which the circumferential surface of the first hole segment transitions to the first surface is small. Therefore, the plate structure manufactured by using the method provided in this embodiment of this application may take into account advantages such as excellent mechanical performance, a small radius of the fillet, and aesthetics.

With reference to the second aspect, in some possible implementations, a stamping temperature of hot-stamping the plate substrate by using the stamping part to form the counterbore and the boss in the plate substrate ranges from 200°C to 280°C. At this temperature, the plate substrate has good thermoplasticity and is easy to stamp.

With reference to the second aspect, in some possible implementations, the stamping part includes an outer cylinder and an inner column that are slidably connected, and the outer cylinder and the inner column are coaxially disposed; and
stamping the plate body by using the stamping part to form the counterbore in the plate body includes:
stamping the plate substrate by using the outer cylinder to form the first hole segment and the boss, and then stamping the boss by using the inner column to form the second hole segment.

With reference to the second aspect, in some possible implementations, a gap between the outer cylinder and the inner column ranges from 0.010 mm to 0.020 mm. Therefore, the gap between the outer cylinder and the inner column is within the foregoing range, so that the outer cylinder and the inner column can move relative to each other, and concentricity of the first hole segment and the second hole segment can be improved.

According to a third aspect, an embodiment of this application provides a plate structure. The plate structure is manufactured by using any method for manufacturing a plate structure according to the second aspect. The plate structure manufactured by using any method for manufacturing a plate structure according to the second aspect may take into account advantages such as excellent mechanical performance, a small radius of the fillet, and aesthetics.

According to a fourth aspect, an embodiment of this application provides an electronic device. The electronic device includes a housing and a printed circuit board. The printed circuit board is located in the housing, the housing includes a locking member and any plate structure according to the first aspect, and the locking member is located in the counterbore and is connected to the counterbore. The plate structure may take into account advantages such as excellent mechanical performance, a small radius of the fillet, and aesthetics, so that the housing including the plate structure may also take into account advantages such as excellent mechanical performance and aesthetics.

### BRIEF DESCRIPTION OF DRAWINGS

FIG. 1a is a diagram of a structure of an electronic device from one perspective according to an embodiment of this application;
FIG. 1b is a diagram of a structure of an electronic device from another perspective according to an embodiment of this application;
FIG. 2 is a diagram of a structure of a plate structure according to an embodiment of this application;
FIG. 3 is a partial diagram of a counterbore according to an embodiment of this application;
FIG. 4 is a diagram of a manufacturing process of a cover body having a stepped hole known by the applicant;
FIG. 5a is a diagram of a method for manufacturing a plate structure according to an embodiment of this application;
FIG. 5b is a diagram of an exploded structure of performing S1 in FIG. 5a;
FIG. 5c is a diagram of an exploded structure of performing S1 in FIG. 5a; and
FIG. 6 is a diagram of an internal structure of a stamping part according to an embodiment of this application.

In the drawings: 100: electronic device; 10: first main body; 21: hinge; 20: second main body; 11: display; 12: keyboard; 13: printed circuit board; 30: housing; 31: rear housing; 32: front housing; 110: locking member; 120: plate structure; 121: plate body; 122: boss; 101: first surface; 102: second surface; 130: counterbore; 131: first hole segment; 132: second hole segment; 103: third surface; 001: cover body; 002: stepped hole; 003: plate; 004: protruding portion; 005: punch; 006: die; 210: base; 211: abutting surface; 212: conical surface; 2121: first edge; 2122: second edge; 41: first reference surface; 42: second reference surface; 401: gap; 50: stamping part; 60: pressure plate; 61: through hole; 213: stamped hole; 214: column body.

### DESCRIPTION OF EMBODIMENTS

To make objectives, technical solutions, and advantages of this application clearer, the following further describes this application in detail with reference to the accompanying drawings.

Terms such as "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

In addition, in embodiments of this application, connection/being connected to may indicate a mechanical connection relationship or a physical connection relationship. To be specific, that A and B are connected or that A is connected to B may indicate that there is a fastening component (like a screw, a bolt, or a rivet) between A and B, or A and B are in contact with each other and A and B are difficult to be separated.

An embodiment of this application provides an electronic device. The electronic device includes but is not limited to a mobile phone, a tablet computer, a desktop computer, a notebook computer, a PDA (personal digital assistant), a wearable device, a display device (like a television), an information display device, a smart home terminal, or the like. In this embodiment of this application, an example in which the electronic device is a notebook computer is used for description.

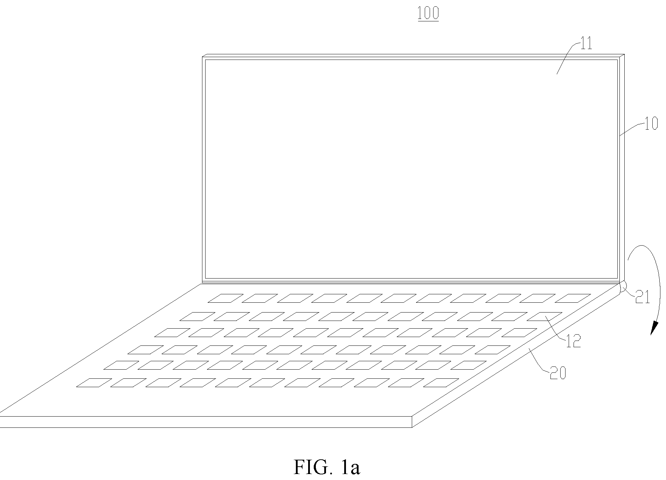

FIG. 1a is a diagram of a structure of an electronic device 100 from one perspective according to an embodiment of this application. Refer to FIG. 1a. The electronic device 100 includes a first main body 10, a hinge 21, and a second main body 20. Both the first main body 10 and the second main body 20 are rotatably connected to the hinge 21, so that an included angle between the first main body 10 and the second main body 20 is adjustable, allowing the first main body 10 and the second main body 20 to be opened and closed.

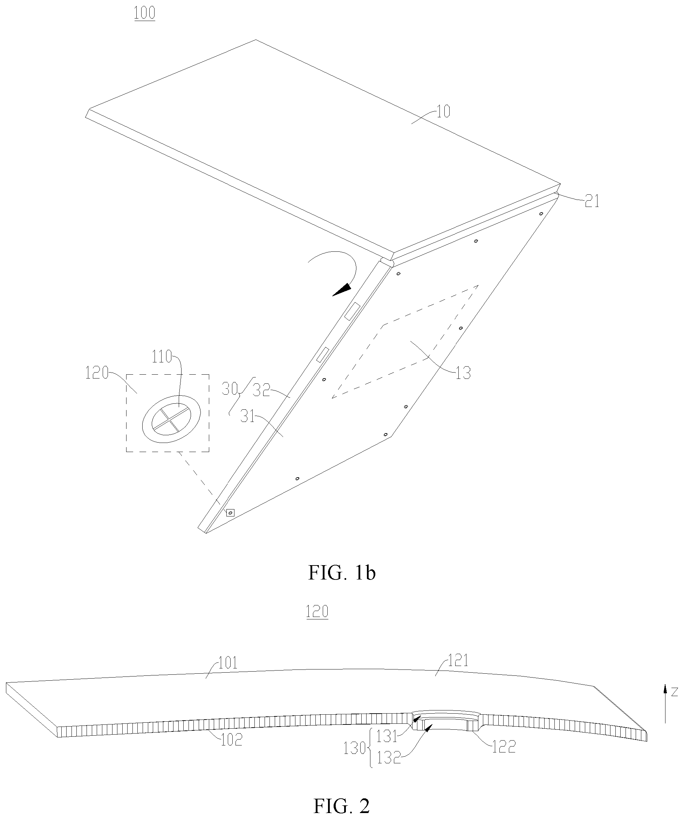

The electronic device 100 further includes a printed circuit board (printed circuit board, PCB) 13 (as shown in FIG. 1b), a display 11, and a keyboard 12. The display 11 is disposed on the first main body 10, the keyboard 12 is disposed on the second main body 20, and the printed circuit board 13 is disposed on the second main body 20.

The display 11 is configured to display an image. In some embodiments, the display 11 may be a liquid crystal display (liquid crystal display, LCD). To provide a light source for the liquid crystal display, a back light unit (back light unit, BLU) located on a back surface of the display 11 may be further disposed on the display 11. The BLU may provide a light source for the liquid crystal display, so that each sub pixel (sub pixel) on the liquid crystal display can emit light to implement image display.

In some embodiments, the display 11 may be an organic light-emitting diode (organic light-emitting diode, OLED) display. Because a light-emitting device OLED in each sub pixel of the OLED display has a light-emitting layer, the OLED display can implement self-emission after receiving a working voltage. In this case, the BLU does not need to be disposed in the display 11 having the OLED display. In some embodiments, the display 11 may be an active-matrix organic light-emitting diode (active-matrix organic light-emitting diode, AMOLED) display, a flexible light-emitting diode (flexible light-emitting diode, FLED) display, a mini-LED display, a micro-LED display, a micro-OLED display, a quantum dot light-emitting diode (quantum dot light-emitting diode, QLED) display, or the like.

In some embodiments, the electronic device 100 may further include devices such as a fan and a speaker. The devices such as the fan and the speaker are disposed on the second main body 20.

FIG. 1b is a diagram of a structure of the electronic device 100 from another perspective according to an embodiment of this application. Refer to FIG. 1b. The second main body 20 includes a housing 30 and the printed circuit board 13, and the printed circuit board 13 is located in the housing 30.

For example, the housing 30 includes a rear housing 31 and a front housing 32. The rear housing 31 and the front housing 32 jointly enclose accommodation space, and devices such as the printed circuit board 13, a battery, and the fan are located in the accommodation space. The keyboard 12 is disposed on the front housing 32, and the rear housing 31 is farther away from the display 11 than the front housing 32.

The housing 30 may further include a locking member 110, and the locking member 110 is connected to the housing 30. For example, both the rear housing 31 and the front housing 32 are connected to the locking member 110, the locking member 110 has a function of locking the housing 30, and the locking member 110 may restrict relative displacement between the rear housing 31 and the front housing 32. In some embodiments, the second main body 20 may further include a middle plate, the middle plate and the rear housing 31 are stacked, and the locking member 110 is connected to the middle plate and the rear housing 31. In some embodiments, the middle plate and the front housing 32 may be connected to form an integrally formed member. In some embodiments, the middle plate and the front housing 32 may be connected in a connection manner like soldering or bonding.

As shown in FIG. 1b, a surface that is of the locking member 110 and that is away from the front housing 32 is located on an outer surface of the electronic device 100, and a surface that is of the rear housing 31 and that is away from the front housing 32 is located on the outer surface of the electronic device 100. When a user uses the electronic device 100, the surface that is of the locking member 110 and that is away from the front housing 32 and the surface that is of the rear housing 31 and that is away from the front housing 32 are within a visible range of the user. Therefore, aesthetics of the surface that is of the locking member 110 and that is away from the front housing 32 and the surface that is of the rear housing 31 and that is away from the front housing 32 affects user experience.

In addition, there is an interaction force between the locking member 110 and the rear housing 31, and structural strength of the rear housing 31 directly affects connection performance between the locking member 110 and the rear housing 31, thereby affecting mechanical performance of the electronic device 100. Therefore, enhancing the structural strength of the rear housing 31 while improving the aesthetics of the surface that is of the rear housing 31 and that is away from the front housing 32 can improve user experience of the electronic device 100.

A type of the locking member 110 is not limited in embodiments of this application. For example, the locking member 110 may be a threaded member (for example, a screw), or the locking member 110 may be a component like a pin.

In some embodiments, the rear housing 31 includes a plate structure 120. Appearance and performance of the plate structure 120 are one of factors that affect appearance and mechanical performance of the rear housing 31. Therefore, an aesthetically pleasing plate structure 120 with high mechanical strength is provided, so that the structure strength of the rear housing 31 is high, and the surface that is of the rear housing 31 and that is away from the front housing 32 is more aesthetically pleasing.

FIG. 2 is a diagram of a structure of the plate structure 120 according to an embodiment of this application. Refer to FIG. 2. The plate structure 120 includes a plate body 121 and a boss 122. The plate body 121 and the boss 122 are connected to form an integrally formed member. The plate body 121 has a first surface 101 and a second surface 102 that are disposed opposite to each other in a thickness direction of the plate body 121, and the plate body 121 is further provided with a counterbore 130. The counterbore 130 penetrates the first surface 101 and the second surface 102 in the thickness direction of the plate body 121. The first surface 101 is an appearance surface. In other words, when the user uses the electronic device, a portion of the first surface 101 or the entire first surface 101 is within the visible range of the user.

For ease of description, the thickness direction of the plate body 121 is defined as a z direction. The counterbore 130 penetrates the plate body 121 in the z direction. The plate body 121 and the boss 122 are stacked in the z direction, and the boss 122 is connected to the second surface 102 of the plate body 121.

The counterbore 130 includes a first hole segment 131 and a second hole segment 132 that communicate with each other, an opening of the first hole segment 131 is located on the first surface 101, and the second hole segment 132 is at least partially formed in the boss 122 and penetrates the boss 122 in the z direction. In other words, the second hole segment 132 penetrates the boss 122, and the entire second hole segment 132 or a portion of the second hole segment 132 is formed in the boss 122. An inner diameter of the first hole segment 131 is greater than an inner diameter of the second hole segment 132.

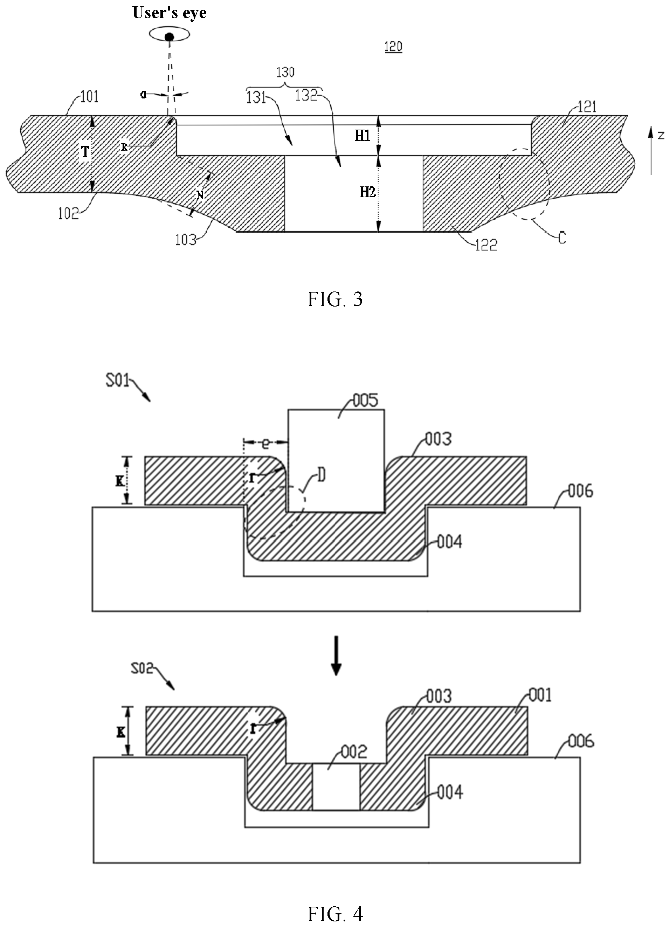

FIG. 3 is a partial diagram of the counterbore 130 according to an embodiment of this application. Refer to FIG. 3. A circumferential surface of the first hole segment 131 smoothly transitions to the first surface 101 via a fillet, and a radius of the fillet is R, where R is less than or equal to 0.3 mm. A minimum distance between the circumferential surface of the first hole segment 131 and a surface that is of the boss 122 and that is away from the plate body 121 is N, where N is greater than or equal to 0.3 mm.

When the user looks at the counterbore 130 from the front while using the electronic device, both the first surface 101 and the fillet via which the circumferential surface of the first hole segment 131 transitions to the first surface 101 may be within a line-of-sight range of the user. For example, when the user views the fillet, a viewing angle of the user is α. In this embodiment of this application, because the radius R of the fillet is small and is less than or equal to 0.3 mm, an area of a circular arc surface via which the circumferential surface of the first hole segment 131 transitions to the first surface 101 is small, the viewing angle α of the user is small, and the area of the circular arc surface observed by the user is small, making the counterbore 130 more aesthetically pleasing.

In addition, the minimum distance N between the circumferential surface of the first hole segment 131 and the surface that is of the boss 122 and that is away from the plate body 121 affects a bearing capacity of the boss 122. A larger N indicates a greater bearing capacity of the boss 122 and higher mechanical performance of the plate structure 120. On the contrary, a smaller N indicates a smaller bearing capacity of the boss 122. Currently, in technical solutions known by the applicant, a small radius R of the fillet and a large minimum distance N cannot be achieved at the same time. In this embodiment of this application, the radius R of the fillet may be less than or equal to 0.3 mm, and at the same time, the minimum distance N may be greater than or equal to 0.3 mm. In this way, the plate structure 120 provided in this embodiment of this application takes into account advantages of aesthetics and good mechanical performance. It is clear that the rear housing 31 (as shown in FIG. 1b) including the plate structure 120 also takes into account advantages of aesthetics and good mechanical performance.

It may be understood that, the fillet via which the circumferential surface of the first hole segment 131 smoothly transitions to the first surface 101 may allow for existence of a manufacturing error.

For ease of description, the surface that is of the boss 122 and that is away from the plate body 121 is defined as a third surface 103. The third surface 103 is connected to the second surface 102. The minimum distance N is a distance between the circumferential surface of the first hole segment 131 and the third surface 103.

For example, the radius R of the fillet may be, for example, 0.3 mm, 0.28 mm, 0.27 mm, 0.26 mm, 0.25 mm, 0.22 mm, 0.20 mm, 0.18 mm, 0.15 mm, 0.13 mm, 0.11 mm, 0.05 mm, or 0.03 mm.

For example, the minimum distance N may be, for example, 0.3 mm, 0.31 mm, 0.32 mm, 0.33 mm, 0.34 mm, 0.35 mm, 0.36 mm, 0.38 mm, 0.4 mm, 0.42 mm, 0.45 mm, 0.48 mm, 0.49 mm, or 0.5 mm.

The foregoing statement "the user looks at the counterbore 130 from the front" means that a line of sight of the user is perpendicular to the first surface 101, or a line of sight of the user is parallel to the circumferential surface of the first hole segment 131.

Shapes of the first surface 101 and the second surface 102 are not limited in embodiments of this application. In some embodiments, the first surface 101 is a flat surface. In some embodiments, based on a shape requirement of the rear housing 31, the first surface 101 may alternatively be in another shape like a curved surface. Similarly, the second surface 102 may be in a shape like a flat surface or a curved surface.

A shape of the first hole segment 131 is not limited in embodiments of this application. In some embodiments, the first hole segment 131 is a cylindrical hole, and the circumferential surface of the first hole segment 131 is cylindrical. In some embodiments, the first hole segment 131 is a prismatic hole, and the circumferential surface of the first hole segment 131 is prismatic. A shape of the second hole segment 132 is not limited in embodiments of this application. The second hole segment 132 may be, for example, a cylindrical hole or a prismatic hole.

Return to FIG. 2. In some embodiments of this application, the surface (the third surface 103) that is of the boss 122 and that is away from the plate body 121 is a frustum surface. The surface that is of the boss 122 and that is away from the plate body 121 is not perpendicular to the first surface 101. The frustum surface is connected to the second surface 102. In this way, the third surface 103 is a frustum surface, so that structural strength of a joint (for example, a region C in FIG. 3) between the boss 122 and the plate body 121 is high. This may improve the bearing capacity of the boss 122, and avoid tearing of the boss 122 and the plate body 121 due to a large interaction force between the boss 122 and the plate body 121.

For example, the third surface 103 is an oblique surface. In other words, the third surface 103 is not parallel to the second surface 102. For example, a tangent line of any point on the third surface 103 is not perpendicular to an axis of the second hole segment 132.

In some embodiments, the bearing capacity of the boss 122 is greater than or equal to 15 kgf (kilogram-force). For example, the bearing capacity of the boss 122 may be 15 kgf, 16 kgf, 17 kgf, 18 kgf, 19 kgf, 20 kgf, 22 kgf, 25 kgf, 26 kgf, or 30 kgf. The bearing capacity of the boss 122 is a minimum force that induces generation of a crack between the boss 122 and the plate body 121.

In some embodiments of this application, a measurement method of the bearing capacity of the boss 122 is as follows: applying a force to the boss 122 until a crack is generated between the boss 122 and the plate body 121. For example, a push-pull gauge is used to push a counterbored hole until a crack is generated between the boss 122 and the plate body 121, and a reading of the push-pull gauge is obtained.

As described above, the inner diameter of the first hole segment 131 is greater than the inner diameter of the second hole segment 132. In embodiments of this application, the inner diameter of the first hole segment 131 and the inner diameter of the second hole segment 132 are not limited, and may be set based on the fastening component.

In some embodiments of this application, a hole depth of the first hole segment 131 is 0.6 times to 0.8 times a thickness of the plate body 121. In FIG. 3, the hole depth of the first hole segment 131 is H1, and the thickness of the plate body 121 is T. H1 ranges from 0.6T to 0.8T. For example, H1 is 0.6T, 0.61T, 0.62T, 0.63T, 0.64T, 0.65T, 0.66T, 0.67T, 0.69T, 0.7T, 0.72T, 0.75T, 0.78T, or 0.8T. The hole depth H1 of the first hole segment 131 and the thickness T of the plate body 121 meet the foregoing relationship, and the minimum distance N is greater than or equal to 0.3 mm, so that the bearing capacity of the boss 122 is large, connection strength between the boss 122 and the plate body 121 is high, and the plate structure 120 has excellent mechanical performance.

The hole depth H1 of the first hole segment 131 is a size of the first hole segment 131 in the z direction. The thickness T of the plate body 121 is a size of the plate body 121 in the z direction. The thickness of the plate body 121 in each region may be equal or not equal. In an embodiment in which the thickness of the plate body 121 in each region is not equal, the thickness T of the plate body 121 is a thickness of the plate body 121 at an edge of the first hole segment 131. For example, the thickness T of the plate body 121 is an average value of thicknesses of the plate body 121 in a range in which a distance to the edge of the first hole segment 131 is less than 0.3 mm.

In some embodiments of this application, the hole depth H1 of the first hole segment 131 ranges from 0.38 mm to 0.48 mm. For example, the hole depth H1 of the first hole segment 131 is 0.38 mm, 0.39 mm, 0.40 mm, 0.41 mm, 0.42 mm, 0.43 mm, 0.44 mm, 0.45 mm, 0.46 mm, 0.47 mm, or 0.48 mm. The hole depth H1 of the first hole segment 131 is within the foregoing range, and the foregoing minimum distance N is greater than or equal to 0.3 mm, so that structural strength between the boss 122 and the plate body 121 is high, and the mechanical performance of the plate structure 120 is excellent.

In some embodiments of this application, the thickness T of the plate body 121 is less than or equal to 0.6 mm. For example, the thickness T of the plate body 121 may be 0.6 mm, 0.55 mm, 0.52 mm, 0.5 mm, or 0.45 mm. A larger thickness T of the plate body 121 indicates a larger size of the plate structure 120; and a larger thickness T of the plate body 121 indicates a larger weight of the plate structure 120. The thickness T is less than or equal to 0.6 mm, and the plate body 121 has characteristics of small thickness and light weight. When the thickness of the plate body 121 is within the foregoing range, the minimum distance N is greater than or equal to 0.3 mm, and the radius R of the fillet is less than or equal to 0.3 mm, the plate structure 120 has a plurality of advantages such as light weight, small thickness, great bearing capacity, and aesthetics.

In addition, in an embodiment in which the hole depth H1 of the first hole segment 131 ranges from 0.38 mm to 0.48 mm, and the thickness T of the plate body 121 is less than or equal to 0.6 mm, the counterbore 130 is formed in the thin plate body 121, a ratio of the hole depth H1 of the first hole segment 131 to the thickness T of the plate body 121 is large, and the plate structure 120 further has an excellent bearing capacity.

In some embodiments of this application, a hole depth H2 of the second hole segment 132 is equal to the thickness T of the plate body 121. The hole depth H2 of the second hole segment 132 is a size of the second hole segment 132 in the z direction. In this embodiment of this application, a difference between the hole depth H2 of the second hole segment 132 and the thickness T of the plate body 121 may allow for existence of a manufacturing error. For example, the hole depth H2 of the second hole segment 132 may be equal to (T ± 0.02) mm.

In some embodiments of this application, the third surface 103 of the boss 122 may be provided with a coating or a plating. The coating or the plating has a function of anti-oxidation. In addition, the coating or the plating further has a decoration function. Similarly, the first surface 101 and the second surface 102 of the plate body 121 may also be provided with a coating or a plating, which may improve a problem of oxidation of the plate body 121, and may further decorate the plate body 121 at the same time.

In some embodiments of this application, a distance between an axis of the first hole segment 131 and an axis of the second hole segment 132 is less than or equal to 0.1 mm. For example, the distance between the axis of the first hole segment 131 and the axis of the second hole segment 132 may be 0.1 mm, 0.09 mm, 0.08 mm, 0.07 mm, 0.06 mm, 0.05 mm, 0.04 mm, 0.03 mm, 0.02 mm, 0.01 mm, or 0 mm. A smaller distance between the axis of the first hole segment 131 and the axis of the second hole segment 132 indicates a higher concentricity of the first hole segment 131 and the second hole segment 132, enhancing both aesthetic appeal of the plate structure 120 and the electronic device.

In some embodiments of this application, a material of the plate structure 120 includes a magnesium alloy, and the magnesium alloy has advantages such as high strength, large elastic modulus, good heat dissipation, excellent shock absorption, and greater impact load bearing capability than an aluminum alloy. Therefore, the plate structure 120 has advantages of light weight and high mechanical strength. In some embodiments, the material of the plate structure 120 may include copper and an alloy thereof, aluminum and an alloy thereof, titanium and an alloy thereof, and the like. Because the boss 122 and the plate body 121 are connected to form an integrally formed member, the boss 122 is made of a same material as that of the plate body 121.

In some embodiments of this application, the material of the plate structure 120 is a plate material. The plate may be, for example, a metal plate manufactured by forging, rolling, or casting. The plate material is different from an extrudate (extrudate), and the extrudate is a material made of iron or steel through a process like rolling, extrusion, or casting. The plate structure 120 that is provided in this embodiment of this application and that is made of the plate material has advantages of high raw material utilization and low manufacturing costs.

In addition, if the plate structure 120 provided in this embodiment of this application is to be manufactured from an extrudate, computer numerical control (computer numerical control, CNC) machining needs to be used. The CNC machining of the extrudate requires processes such as cutting, and milling and polishing, and requires a large quantity of raw materials. This results in low utilization of the raw materials in a machining process, and high manufacturing costs of the CNC machining. In addition, the CNC-machined extrudate exhibits a high surface roughness, and has machining tool marks on a surface. A surface of the plate structure 120 provided in this embodiment of this application may be free of tool marks, for example, is a smooth surface.

The plate structure 120 cannot be manufactured by using a process known by the applicant.

FIG. 4 is a diagram of a manufacturing process of a cover body 001 having a stepped hole 002 known by the applicant. The manufacturing process in FIG. 4 includes the following steps.

S01: Form a protruding portion 004 on a plate 003 by using a heat-stamping process.

The plate 003 is located between a punch 005 and a die 006, and in a direction parallel to the plate 003, a distance between the punch 005 and the die 006 is e.

S02: Stamp the protruding portion 004 by using a cold-stamping process to form the stepped hole 002.

In the process in FIG. 4, to ensure high connection strength between the protruding portion 004 and the plate 003, a size of a joint (for example, a region D in FIG. 4) between the protruding portion 004 and the plate 003 needs to be large. In this case, the distance e between the punch 005 and the die 006 needs to be large. For example, the distance e is equal to a thickness K of the plate 003, to avoid weak connection strength between the protruding portion 004 and the plate 003 due to a small thickness at the region D.

The distance e between the punch 005 and the die 006 is one of factors that affect a radius r a fillet between a circumferential surface of the protruding portion 004 and a surface of the plate 003. A larger distance e between the punch 005 and the die 006 indicates a larger radius r of the fillet. On the contrary, to ensure that the radius r of the fillet is small, the distance e between the punch 005 and the die 006 needs to be small, and the small distance e causes low connection strength between the protruding portion 004 and the plate 003.

For example, in FIG. 4, to enable a bearing capacity of the protruding portion 004 to reach 15 kgf, the distance e between the punch 005 and the die 006 needs to be close to the thickness K of the plate 003. Generally, the thickness K of the plate 003 is 0.6 mm, and therefore, the distance e between the punch 005 and the die 006 is 0.6 mm, the radius r of the fillet is equal to the distance e, and the radius r of the fillet is 0.6 mm. It is clear that the radius r of the fillet is far greater than 0.3 mm. In other words, the cover body 001 with the radius r of the fillet being less than or equal to 0.3 mm and a minimum size of the region D being greater than or equal to 0.3 mm cannot be obtained by using the process in FIG. 4.

In addition, in the example in FIG. 4, the stepped hole 002 is formed by penetrating the protruding portion 004. In a process of penetrating the protruding portion 004, it is difficult to locate an axis of the protruding portion 004, and consequently, a concentricity of the stepped hole 002 is poor.

Therefore, an embodiment of this application provides a method for manufacturing the plate structure 120.

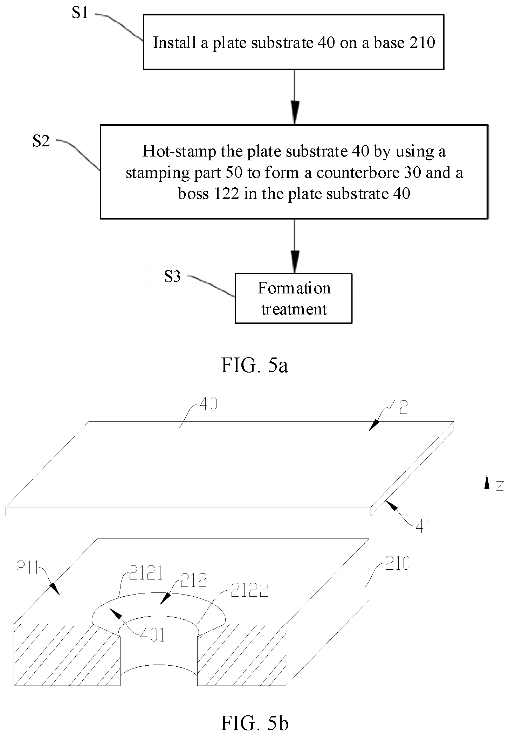

FIG. 5a is a diagram of a method for manufacturing the plate structure 120 according to an embodiment of this application. Refer to FIG. 5a. The method for manufacturing the plate structure 120 includes the following steps.

S1: Install a plate substrate 40 on a base 210, as shown in FIG. 5b.

FIG. 5b is a diagram of an exploded structure of performing S1 in FIG. 5a. In a process of performing S1, the base 210 and the plate substrate 40 are stacked.

As shown in FIG. 5b, the plate substrate 40 has a first reference surface 41 and a second reference surface 42 that are disposed opposite to each other in a thickness direction of the plate substrate 40. The base 210 has an abutting surface 211 and a conical surface 212, and both the abutting surface 211 and the conical surface 212 face the plate substrate 40. The abutting surface 211 is in intimate contact with the first reference surface 41, and a gap 401 exists between the conical surface 212 and the first reference surface 41.

In FIG. 5b, the conical surface 212 has a first edge 2121 and a second edge 2122, the first edge 2121 is connected to the first reference surface 41, the second edge 2122 is farther away from the first reference surface 41 relative to the first edge 2121, and a radius of the first edge 2121 is greater than a radius of the second edge 2122.

A size of a conical angle of the conical surface 212 is not limited in embodiments of this application. For example, the conical angle ranges from 20° to 70°, and the conical angle may be, for example, 20°, 25°, 30°, 35°, 40°, 45°, 50°, 55°, 60°, 65°, or 70°.

In some embodiments, the conical surface 212 transitions to the first reference surface 41 via an arc. In other words, a fillet is provided at the first edge 2121. A height of the conical surface 212 may be set based on a height requirement of the second hole segment 132. In some embodiments, no fillet may alternatively be provided at the first edge 2121.

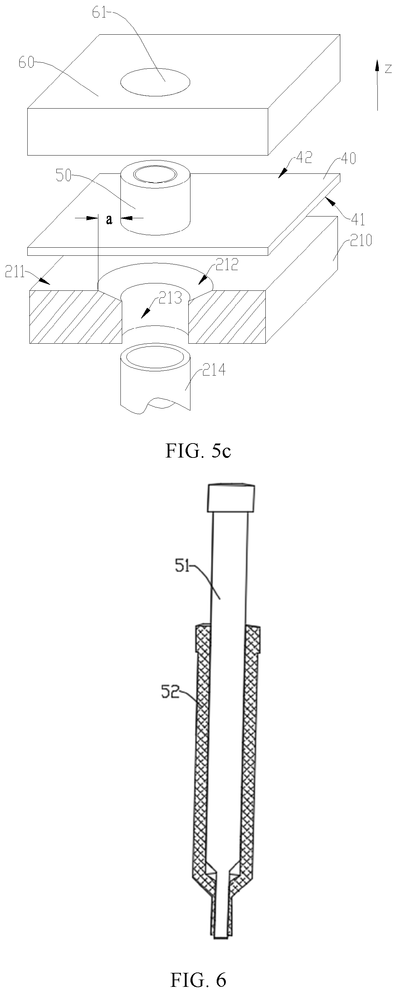

S2: Hot-stamp the plate substrate 40 by using a stamping part 50 to form a counterbore and a boss in the plate substrate 40, as shown in FIG. 5c.

A structure after S1 in FIG. 5a is performed is shown in FIG. 2. The counterbore 130 includes the first hole segment 131 and the second hole segment 132 that communicate with each other, the opening of the first hole segment 131 is located on the first surface 101, and the second hole segment 132 is at least partially formed in the boss 122 and penetrates the boss 122 in the z-direction. The inner diameter of the first hole segment 131 is greater than the inner diameter of the second hole segment 132. The circumferential surface of the first hole segment 131 smoothly transitions to the first surface 101 via the fillet. A thickness T of the plate substrate 40 is the thickness T of the plate body 121.

FIG. 5c is a diagram of an exploded structure of performing S1 in FIG. 5a. Refer to FIG. 5c. In a direction perpendicular to the thickness direction (z direction) of the plate substrate 40, a distance between the stamping part 50 and the abutting surface 211 is a. The thickness of the plate substrate 40 is T (as shown in FIG. 3), and a is equal to (0.3 to 0.5)T. For example, a is 0.3T, 0.31T, 0.32T, 0.33T, 0.34T, 0.35T, 0.36T, 0.38T, 0.40T, 0.42T, 0.45T, 0.48T, or 0.50T.

The gap 401 exists between the conical surface 212 and the first reference surface 41. In a process in which the stamping part 50 hot-stamps the plate substrate 40, the plate substrate 40 moves close to the conical surface 212 after deformation until the conical surface 212 abuts against the plate substrate 40. In a process in which the stamping part 50 continues to stamp the plate substrate 40, the conical surface 212 and the stamping part 50 extrude the plate substrate 40 together until the counterbore 130 (as shown in FIG. 3) and the boss 122 (as shown in FIG. 3) are formed. In addition, in an extruding process of the conical surface 212 and the stamping part 50, an oblique surface (for example, the third surface 103 in FIG. 3) may be formed on a surface that is of the boss 122 and that is away from the plate body 121, and a high-strength connecting material may be formed between the boss 122 and the plate body 121.

Under the action of the conical surface 212 and the stamping part 50, a portion of a material of the plate substrate 40 accumulates in a region C (as shown in FIG. 3) between the boss 122 and the plate body 121 (as shown in FIG. 3), so that the region C is thickened. In this way, even if the distance a between the stamping part 50 and the abutting surface 211 is small, the region C may still be thick. This helps increase the minimum distance N shown in FIG. 3, thereby ensuring that bearing strength and mechanical performance of the plate structure 120 are excellent. In addition, the distance a between the stamping part 50 and the abutting surface 211 is smaller than the thickness T of the plate body 121. The radius R of the fillet via which the circumferential surface of the first hole segment 131 transitions to the first surface 101 is small, and is less than or equal to 0.3 mm. Therefore, the plate structure 120 manufactured by using the method provided in this embodiment of this application may take into account advantages such as excellent mechanical performance, a small radius R of the fillet, and aesthetics.

It is assumed that the base 210 is not provided with the conical surface 212, and correspondingly, the base 210 does not have the gap 401. The distance a between the stamping part 50 and the abutting surface 211 is small (for example, a is 0.5T). In the process in which the stamping part 50 hot-stamps the plate substrate 40, the base 210 leaves no space between the plate body 121 and the boss 122 to accommodate a material, and a thickness of the joint between the plate body 121 and the boss 122 is close to the distance a between the stamping part 50 and the abutting surface 211. The distance a is small, so that the thickness of the joint between the plate body 121 and the boss 122 is also small. As a result, the connection strength between the plate body 121 and the boss 122 is low, and bearing capacities of the plate body 121 and the boss 122 decrease accordingly. On the contrary, it is assumed that the base 210 is not provided with the conical surface 212, and the distance a between the stamping part 50 and the abutting surface 211 is large (for example, a is T). In the process in which the stamping part 50 hot-stamps the plate substrate 40, the distance a between the stamping part 50 and the abutting surface 211 is large, so that the thickness of the joint between the plate body 121 and the boss 122 is correspondingly large (close to T). As a result, the connection strength between the plate body 121 and the boss 122 is high. However, because the distance a is large, the radius of the fillet via which the circumferential surface of the first hole segment 131 transitions to the first surface 101 is large, and aesthetics is affected.

The foregoing statement "the abutting surface 211 is in intimate contact with the first reference surface 41" means that the first reference surface 41 and the abutting surface 211 have a same shape, and the first reference surface 41 abuts against the abutting surface 211. In the stamping process, the first reference surface 41 undergoes slight or almost no deformation.

The first reference surface 41 of the plate substrate 40 forms the second surface 102 shown in FIG. 3 after undergoing S1 and S2 in FIG. 5a, and the second reference surface 42 forms the first surface 101 shown in FIG. 3 after undergoing S1 and S2 in FIG. 5a. The thickness T of the plate substrate 40 is the thickness of the plate body 121.

A shape and a material of the plate substrate 40 are not limited in embodiments of this application. A structure of the plate substrate 40 may be set based on a shape requirement and a material requirement of the plate structure 120. For example, the plate substrate 40 is a plate material with a uniform thickness. The material of the plate substrate 40 may be, for example, a magnesium alloy, copper and an alloy thereof, aluminum and an alloy thereof, or titanium and an alloy thereof.

For example, a temperature of hot stamping for performing S1 may range from 200°C to 280°C. For example, the temperature of hot stamping may be 200°C, 210°C, 220°C, 230°C, 250°C, 260°C, 270°C, or 280°C. At this temperature, the plate substrate 40 has good thermoplasticity and is convenient for stamping. In an embodiment in which the material of the plate substrate 40 is a magnesium alloy, the magnesium alloy has good plasticity at a temperature ranging from 200°C to 280°C, which is conducive to hot stamping.

It may be understood that, in some embodiments of this application, the base 210, the stamping part 50, and the plate substrate 40 may be separately heated and then S2 in FIG. 5a is performed. For example, the plate substrate 40 is heated separately, the base 210 and the stamping part 50 are heated together, the base 210 and the plate substrate 40 are installed, and then S2 in FIG. 5a is performed for stamping. This can save stamping time. In some embodiments of this application, the base 210, the stamping part 50, and the plate substrate 40 may be heated together after being installed, and then stamping is performed.

Return to FIG. 5c. In some embodiments, to avoid deformation of the plate substrate 40 in a stamping process, a pressure plate 60 is further disposed on a side that is of the plate substrate 40 and that is away from the base 210. The pressure plate 60 and the plate substrate 40 are stacked, and the pressure plate 60 is in intimate contact with the first reference surface 41. In the stamping process, the pressure plate 60 and the first reference surface 41 that are in intimate contact avoid deformation of the first reference surface 41.

For example, the pressure plate 60 is further provided with a through hole 61. In the stamping process, the stamping part 50 passes through the through hole 61 to apply an action force to the plate substrate 40, so that the plate substrate 40 deforms and the counterbore 130 (as shown in FIG. 2) is formed.

The base 210 may be further provided with a stamped hole 213, and the stamped hole 213 penetrates the base 210 in the z direction. The base 210 is further provided with a column body 214. The column body 214 is located in the stamped hole 213. The column body 214 is slidably connected to the stamped hole 213, and an outer diameter of the column body 214 is the same as the inner diameter of the second hole segment 132 (as shown in FIG. 2). In the stamping process, the stamping part 50 performs stamping on the plate substrate 40, and the stamping part 50 moves close to the column body 214 in the z direction until the stamping part 50 abuts against the column body 214 and the counterbore 130 (as shown in FIG. 2) is formed in the plate substrate 40.

A shape of the pressure plate 60 is not limited in embodiments of this application, provided that the pressure plate 60 is in intimate contact with the first reference surface 41. For example, the pressure plate 60 may be a circular plate or a square plate. For example, a hardness of the pressure plate 60 may be Rockwell hardness (HRC) 59 ± 1, and the hardness of the pressure plate 60 is, for example, HRC 58, HRC 59, or HRC 60.

For example, a hardness of the column body 214 may be HRC 59 ± 1, and the hardness of the column body 214 is, for example, HRC 58, HRC 59, or HRC 60. A hardness of the base 210 may be HRC 60 ± 1, and the hardness of the base 210 is, for example, HRC 59, HRC 60, or HRC 61.

FIG. 6 is a diagram of an internal structure of the stamping part 50 according to an embodiment of this application. Refer to FIG. 6. The stamping part 50 (as shown in FIG. 5c) includes an outer cylinder 52 and an inner column 51. The outer cylinder 52 and the inner column 51 are coaxially disposed, and the outer cylinder 52 and the inner column 51 are slidably connected.

S2 in FIG. 5a includes: stamping the plate substrate 40 by using the outer cylinder 52 to form the first hole segment 131 and the boss 122; and stamping the boss 122 by using the inner column 51 to form the second hole segment 132.

Because the outer cylinder 52 and the inner column 51 are coaxially disposed, the distance between the axis of the first hole segment 131 and the axis of the second hole segment 132 is small and approaches zero. The first hole segment 131 and the second hole segment 132 exhibit high concentricity.

A manner in which the outer cylinder 52 and the inner column 51 are slidably connected is not limited in embodiments of this application. For example, the outer cylinder 52 is sleeved outside the inner column 51, and a gap exists between the outer cylinder 52 and the inner column 51, so that the outer cylinder 52 and the inner column 51 slide relative to each other. Alternatively, the outer cylinder 52 and the inner column 51 are slidably connected via a sliding rail.

For example, the gap between the outer cylinder 52 and the inner column 51 ranges from 0.010 mm to 0.020 mm. For example, the gap may be 0.010 mm, 0.015 mm, or 0.020 mm. The gap between the outer cylinder 52 and the inner column 51 is within the foregoing range, so that the outer cylinder 52 and the inner column 51 can move relative to each other, and the concentricity of the first hole segment 131 and the second hole segment 132 can be improved.

A hardness of the outer cylinder 52 and the inner column 51 is not limited in embodiments of this application, and may be set based on the plate substrate 40. For example, the hardness of the outer cylinder 52 and the inner column 51 may be Rockwell hardness (HRC) 70 ± 1, and the hardness of the outer cylinder 52 and the inner column 51 is, for example, HRC 69, HRC 70, or HRC 71.

Return to FIG. 5a. In some embodiments, after S2 is performed, the method may further include the following step.

S3: Formation treatment.

The formation treatment is a process of treating a metal surface through a chemical or electrochemical (electrochemical) method to obtain a coating (coating) of a compound of the metal (compound of the metal).

In some embodiments, the formation treatment may include: grinding and cleaning, micro-arc oxidation treatment, spray coating treatment, and the like.

In the descriptions of this specification, specific features, structures, materials, or characteristics may be combined in a proper manner in any one or more of embodiments or examples.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A plate structure, wherein the plate structure comprises:
a plate body, wherein the plate body has a counterbore, and a first surface and a second surface that are disposed opposite to each other in a thickness direction of the plate body; and
a boss, wherein the boss is connected to the second surface and is connected to the plate body to form an integrally formed member; and
the counterbore comprises a first hole segment and a second hole segment that communicate with each other, an opening of the first hole segment is located on the first surface, the second hole segment is at least partially formed in the boss and penetrates the boss in the thickness direction of the plate body, an inner diameter of the first hole segment is greater than an inner diameter of the second hole segment, a circumferential surface of the first hole segment smoothly transitions to the first surface via a fillet, a radius of the fillet is less than or equal to 0.3 mm, and a minimum distance between the circumferential surface of the first hole segment and a surface that is of the boss and that is away from the plate body is greater than or equal to 0.3 mm.

2. The plate structure according to claim 1, wherein a surface that is of the boss and that is away from the first surface is a frustum surface, and the frustum surface is connected to the second surface.

3. The plate structure according to claim 1 or 2, wherein in the thickness direction of the plate body, a hole depth of the second hole segment is equal to a thickness of the plate body.

4. The plate structure according to any one of claims 1 to 3, wherein in the thickness direction of the plate body, a hole depth of the first hole segment ranges from 0.6 times to 0.8 times the thickness of the plate body.

5. The plate structure according to any one of claims 1 to 4, wherein the hole depth of the first hole segment ranges from 0.38 mm to 0.48 mm.

6. The plate structure according to any one of claims 1 to 5, wherein the thickness of the plate body is less than or equal to 0.6 mm.

7. The plate structure according to any one of claims 1 to 6, wherein a material of the plate structure comprises a magnesium alloy.

8. The plate structure according to any one of claims 1 to 7, wherein the material of the plate structure is a plate material.

9. The plate structure according to any one of claims 1 to 8, wherein a distance between an axis of the first hole segment and an axis of the second hole segment is less than or equal to 0.1 mm.

10. A method for manufacturing a plate structure, comprising:
installing a plate substrate on a base, wherein the plate substrate has a first reference surface and a second reference surface that are disposed opposite to each other in a thickness direction of the plate substrate, the base has an abutting surface and a conical surface, both the abutting surface and the conical surface face the plate substrate, the abutting surface is in intimate contact with the first reference surface, and a gap exists between the conical surface and the first reference surface; and
hot-stamping the plate substrate by using a stamping part to form a counterbore and a boss in the plate substrate, wherein
a distance between the stamping part and the abutting surface is a in a direction perpendicular to the thickness direction of the plate substrate; and
the counterbore comprises a first hole segment and a second hole segment that communicate with each other, an opening of the first hole segment is located on the first reference surface, the second hole segment is at least partially formed in the boss and penetrates the boss in the thickness direction of the plate substrate, an inner diameter of the first hole segment is greater than an inner diameter of the second hole segment, a circumferential surface of the first hole segment smoothly transitions to the first reference surface via a fillet, a radius of fillet is less than or equal to 0.3 mm, a thickness of the plate substrate is T, and a is equal to (0.3 to 0.5)T.

11. The method for manufacturing a plate structure according to claim 10, wherein a stamping temperature of hot-stamping the plate substrate by using the stamping part to form the counterbore and the boss in the plate substrate ranges from 200°C to 280°C.

12. The method for manufacturing a plate structure according to claim 10 or 11, wherein the stamping part comprises an outer cylinder and an inner column that are slidably connected, and the outer cylinder and the inner column are coaxially disposed; and
stamping the plate substrate by using the stamping part to form the counterbore in the plate substrate comprises:
stamping the plate substrate by using the outer cylinder to form the first hole segment and the boss, and then stamping the boss by using the inner column to form the second hole segment.

13. The method for manufacturing a plate structure according to claim 12, wherein a gap between the outer cylinder and the inner column ranges from 0.010 mm to 0.020 mm.

14. A plate structure, wherein the plate structure is manufactured by using the method for manufacturing a plate structure according to any one of claims 10 to 13.

15. An electronic device, wherein the electronic device comprises a housing and a printed circuit board, the printed circuit board is located in the housing, the housing comprises a locking member and the plate structure according to any one of claims 1 to 9 or claim 14, and the locking member is located in the counterbore and is connected to the counterbore.
